# EUROPÄISCHE PATENTANMELDUNG

(11) **EP 0 854 576 A2**
(43) Veröffentlichungstag der Anmeldung: **22.07.1998**
(21) Anmeldenummer: 97118072.4
(22) Anmeldetag: 17.10.1997
(51) Int. Cl.: H03K 17/95

(54) **Sensor mit Gehäuse**

(30) Priorität: 20.01.1997 DE 19701788
(71) Anmelder: Sick AG, 79183 Waldkirch, Breisgau (DE)
(72) Erfinder: Bauer, Robert, 79312 Emmendingen (DE)
(74) Vertreter: Finsterwald, Martin, Dr.

(57) **Zusammenfassung**

Die Erfindung betrifft einen Sensor, insbesondere optoelektronischer, induktiver oder magnetischer Sensor mit in einem Gehäuse angeordneten elektronischen Bauteilen und von der Gehäuseaußenseite zugänglichen Anschlußelementen, wobei die elektronischen Bauteile bei weiterhin zugänglichen Anschlußelemeneten zumindest großteils mit Kunststoffmasse umspritzt sind, die die elektronischen Bauteile umgebende Kunststoffmasse einen festen Formkörper bildet, welcher zumindest teilweise in ein Hülsenelement einführbar ist, und Mittel zur Fixierung der relativen Position zwischen Formkörper und Hülsenelement vorgesehen sind.

## Beschreibung

Die Erfindung betrifft einen Sensor, insbesondere einen optoelektronischen, induktiven oder magnetischen Sensor mit in einem Gehäuse angeordneten elektronischen Bauteilen und von der Gehäuseaußenseite zugänglichen Anschlußelementen.

Bei bekannten Sensoren werden beispielsweise auf einer Platine angeordnete elektronische Bauteile in ein vorgefertigtes Gehäuse eingeführt, woraufhin die zwischen Platine und Gehäuseinnenseite bestehenden Zwischenräume mit flüssigem Kunststoffmaterial, insbesondere mit Epoxydmasse ausgefüllt werden.

Dieses Herstellungsverfahren erfordert einerseits wegen des Arbeitsschritts des Vergießens und andererseits wegen oftmals langer Trocknungszeiten der Vergußmasse einen hohen Aufwand, was sich negativ auf die Wirtschaftlichkeit des Herstellungsverfahrens auswirkt.

Eine Aufgabe der Erfindung besteht darin, einen Sensor der eingangs genannten Art derart weiterzubilden, daß seine Herstellung vereinfacht wird.

Erfindungsgemäß wird diese Aufgabe dadurch gelöst, daß die elektronischen Bauteile bei weiterhin zugänglichen Anschlußelementen zumindest großteils mit Kunststoffmasse umspritzt sind, daß die die elektronischen Bauteile umgebende Kunststoffmasse einen festen Formkörper bildet, welcher zumindest teilweise in ein Hülsenelement einführbar ist, und daß Mittel zur Fixierung der relativen Position zwischen Formkörper und Hülsenelement vorgesehen sind.

Erfindungsgemäß werden die elektronischen Bauteile also nicht in einem Gehäuseelement vergossen, sondern in einem ersten Arbeitsschritt mit Kunststoffmasse umspritzt, wodurch ein fester Formkörper entsteht, in dem die elektronischen Bauteile in das Spritzmaterial eingebettet sind. Dieser Formkörper weist unmittelbar nach dem Spritzvorgang noch kein Gehäuse auf, da erst nachträglich, d.h. nach abgeschlossenem Spritzvorgang der Formkörper in ein separat gefertigtes Hülsenelement eingeführt und dort fixiert wird.

Ein wesentlicher Vorteil der Erfindung ist zum einen darin zu sehen, daß das Spritzmaterial sehr schnell härtet, was die Herstellungszeiten verkürzt. Zum anderen kann ein einheitlicher, standardisierter Formkörper ohne weiteres mit Hülsenelementen verschiedener Bauformen kombiniert werden, um auf diese Weise hinsichtlich der Abmessungen des fertigen Sensors individuellen Kundenwünschen Rechnung tragen zu können, ohne den gesamten Herstellungsprozeß wesentlich verändern zu müssen.

Die Verbindung zwischen Formkörper und Hülsenelement gestaltet sich beispielsweise dann besonders einfach, wenn der Formkörper mit Vertiefungen versehen wird, in die benachbart zu diesen Vertiefungen gelegene Bereiche des Hülsenelements eingedrückt sind, um auf diese Weise die gewünschte Fixierung zu erreichen. Die Vertiefungen können dabei die Form einer oder mehrerer Nuten aufweisen, insbesondere wird der Formkörper mit zwei oder mehreren, entlang seines Umfangs verlaufenden Ringnuten versehen. Das Hülsenelement kann dann in seinen benachbart zu den Ringnuten gelegenen Bereichen gebördelt werden, wodurch sich das Hülsenmaterial in die Ringnuten hineinerstreckt und eine formschlüssige Verbindung zwischen Hülsenelement und Formkörper herstellt.

Grundsätzlich ist es möglich, Hülsenelement und Formkörper an einer oder mehreren Stellen miteinander zu verbinden. Auch eine vollflächige Verbindung von Hülsenelement und Formkörper ist möglich.

In einer weiteren bevorzugten Ausführungsform der Erfindung kann das Hülsenelement auf den Formkörper aufgeschrumpft oder aufgeschraubt werden. In letztgenanntem Fall ist es von Vorteil, wenn das Hülsenelement auf seiner Innenseite mit einem Gewinde versehen wird, insbesondere kann hier ein selbstschneidendes Gewinde vorgesehen werden, welches beim Aufschrauben auf den Formkörper an dessen Außenseite ein entsprechendes Gewinde erzeugt.

In einer weiteren Ausführungsform der Erfindung können Hülsenelement und Formkörper miteinander verklebt und/oder verpreßt werden.

Schließlich ist es auch möglich, den Formkörper mit dem Hülsenelement galvanisch zu überziehen.

Bei allen vorstehend beschriebenen Befestigungsverfahren muß lediglich sichergestellt sein, daß der Formkörper separat vom Hülsenelement herstellbar und nachträglich mit diesem verbindbar ist.

In einer bevorzugten Ausführungsform der Erfindung weist das Hülsenelement zumindest im wesentlichen eine hohlzylindrische Form auf, wobei der Innenumfang des Hohlzylinders im wesentlichen dem Außenumfang des Formkörpers entspricht.

Der Außenumfang bzw. die Außenkontur des Hülsenelements kann beliebige Formen annehmen und individuell an die jeweils gegebenen Anforderungen angepaßt werden. Bei üblichen Anwendungsfällen wird die Außenkontur des Hülsenelements rund, quadratisch oder rechteckig sein. Andere Formen sind jedoch ohne weiteres realisierbar.

Es ist nicht zwingend nötig, daß das Hülsenelement die ihm zugewandte Außenseite des Formkörpers vollständig bedeckt. In bestimmten Anwendungsfällen ist es ausreichend, wenn das Hülsenelement den Formkörper nur teilweise, beispielsweise ungefähr zur Hälfte bedeckt.

Je nach Anforderung kann das Hülsenelement aus Metall oder Kunststoff bestehen. Dabei ist es auch möglich, das Hülsenelement aus dem Spritzmaterial zu fertigen, das zur Herstellung des Formkörpers verwendet wird.

Die Außenseite des Hülsenelements kann im wesentlichen glatt ausgebildet sein oder aber für bestimmte Anwendungsfälle auch mit einem Gewinde versehen werden, um so den fertigen Sensor in einer entsprechenden Halterung fixieren zu können.

Ein wesentlicher Vorteil der Erfindung ist darin zu sehen, daß der Formkörper in Hülsenelementen unterschiedlicher Abmessungen fixierbar ist. Insbesondere ist ein einheitlicher, im wesentlichen zylindrischer Formkörper in unterschiedlichen hohlzylindrischen Hülsenelementen fixierbar, deren Innenumfang jeweils dem Außenumfang des Formkörpers entspricht, wobei jedoch der Außenumfang bzw. die Außenkontur der Hülsenelemente unterschiedlich ausgebildet sein kann, um so den jeweils gegebenen Anforderungen Rechnung tragen zu können.

Um den elektrischen Anschluß eines erfindungsgemäßen Sensors bewerkstelligen zu können, kann im Formkörper ein umspritzter Anschlußstecker vorgesehen werden.

Alternativ ist es möglich, im Formkörper lediglich umspritzte Anschlußkontakte vorzusehen, an die nachträglich ein an jeweils gegebene Anforderungen anpassbarer Anschlußstecker ankoppelbar ist. Bevorzugt wird ein Satz von Anschlußsteckern bereitgestellt, welcher einerseits Buchsen oder Stecker aufweist, die mit den einheitlichen Anschlußkontakten des Formkörpers koppelbar sind und andererseits aber auch Stecker bzw. Buchsen zum elektrischen Anschluß des Sensors und eine beliebige Peripherie aufweist, wobei diese Stecker bzw. Buchsen verschieden ausgebildet und an die jeweiligen Anforderungen angepaßt sein können.

Durch die letztgenannte, bevorzugte Ausführungsform der Erfindung kann nicht nur die äußere Form des Sensors an individuelle Kundenwünsche angepaßt werden, sondern es ist darüber hinaus auch möglich, individuellen Wünschen der Kunden hinsichtlich des elektrischen Anschlusses der Sensoren Rechnung zu tragen, ohne den Formkörper für verschiedene Anwendungen verändern zu müssen.

Bei der letztgenannten Ausführungsform der Erfindung ist es von Vorteil, wenn der nachträglich angekoppelte Anschlußstecker zumindest bereichsweise vom Hülsenelement umgeben und bevorzugt mit diesem verbunden und auf diese Weise fixiert ist. Die Außenkontur des Anschlußsteckers weist dabei bevorzugt die gleiche Form wie die Außenkontur des Formkörpers auf.

Die Erfindung erstreckt sich auch auf ein Verfahren zur Herstellung eines Sensors der vorstehend beschriebenen Art, bei dem zuerst das Formteil und das Hülsenelement als zwei voneinander unabhängige Bauteile in separaten Arbeitsschritten hergestellt werden und anschließend das Formteil in das Hülsenteil eingeführt und in diesem fixiert wird.

Weitere bevorzugte Ausführungsformen der Erfindung sind in den Unteransprüchen angegeben.

Die Erfindung wird nachfolgend anhand von Ausführungsbeispielen unter Bezugnahme auf die Zeichnungen beschrieben; in diesen zeigen:
- Fig. 1a bis 1c: das Prinzipschaubild eines erfindungsgemäßen Sensors in drei unterschiedlichen Phasen seiner Herstellung,
- Fig. 2a bis 2c: einen erfindungsgemäßen Formkörper in Verbindung mit unterschiedlichen Hülsenelementen, und
- Fig. 3a, 3b: zwei unterschiedliche Möglichkeiten der Realisierung elektrischer Anschlußelemente eines erfindungsgemäßen Sensors.

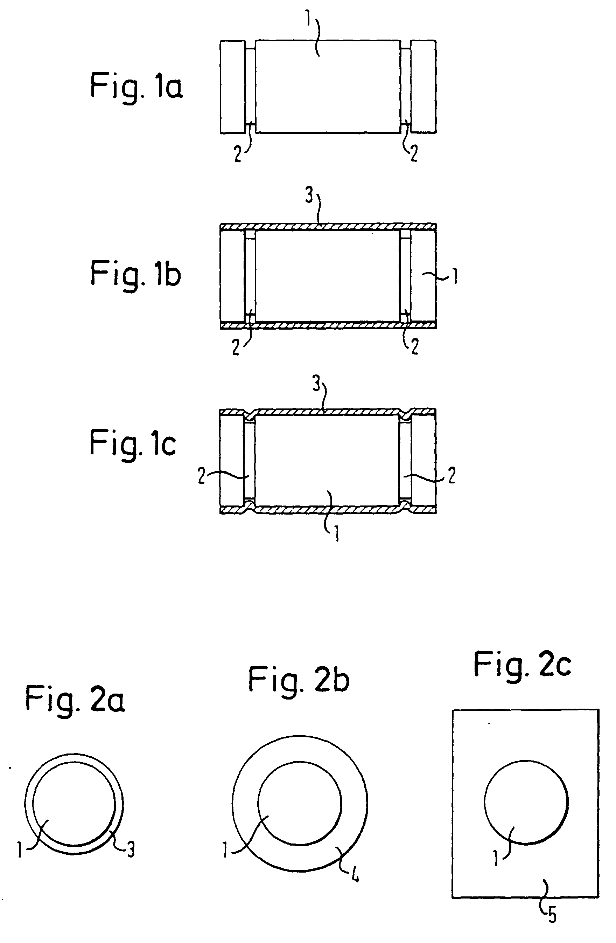

Fig. 1a zeigt eine schematische Seitenansicht eines in einem erfindungsgemäßen Sensor verwendbaren Formkörpers 1, welcher im wesentlichen eine zylindrische Form aufweist.

Dieser Formkörper ist mit zwei sich parallel zueinander erstreckenden und voneinander beabstandeten Ringnuten 2 versehen, die sich jeweils entlang einer Umfangslinie des zylindrischen Formkörpers 1 erstrecken.

In den Formkörper 1 sind in der Darstellung nicht sichtbare elektronische Bauteile eingebettet.

Fig. 1b zeigt einen parallel zur Zeichenebene durch die Mittelachse des zylindrischen Formkörpers 1 verlaufende Schnittdarstellung, bei der der Formkörper 1 in ein aus Metall bestehendes Hülsenelement 3 eingeführt ist. Das Hülsenelement 3 weist im wesentlichen hohlzylindrische Form auf, wobei der Innendurchmesser des Hülsenelements 3 etwas größer als der Außendurchmesser des Formkörpers 1 ist. Die Längserstreckungen von Hülsenelement 3 und Formkörper 1 sind gleich groß.

Bei dem in Fig. 1b dargestellten Herstellungsschritt ist der Formkörper 1 entlang seiner Mittelachse frei im Hülsenelement 3 verschiebbar.

Um den Formkörper 1 im Hülsenelement 3 zu fixieren, wird das Hülsenelement 3 gemäß Fig. 1c im Bereich der Ringnuten 2 des Formkörpers 1 gebördelt. Auf diese Weise gelangen Bereiche des Hülsenelements 3 in die Nuten 2, so daß der Formkörper 1 im Hülsenelement 3 nicht mehr verschiebbar ist.

Die Fig. 2a bis 2c zeigen eine schematische Draufsicht auf die kreisrunde Stirnseite eines Formkörpers 1 gemäß Fig. 1.

In Fig. 2a ist der Formkörper 1 mit einem relativ dünnwandigen hohlzylindrischen Hülsenelement 3 gemäß Fig. 1 verbunden.

Fig. 2b zeigt, daß der gleiche Formkörper 1 jedoch auch in einem hohlzylindrischen Hülsenelement 4 mit deutlich größerer Wandstärke angeordnet werden kann, um auf diese Weise Anforderungen von Kunden befriedigen zu können, welche einen Sensor mit vergrößertem Außenumfang benötigen.

Fig. 2c zeigt, daß das Hülsenelement 5 bei Verwendung des einheitlichen Formkörpers 1 auch beliebige andere Formen, beispielsweise eine rechteckige Außenkontur aufweisen kann. So lassen sich Spezialwünsche von Kunden in beliebiger Weise befriedigen.

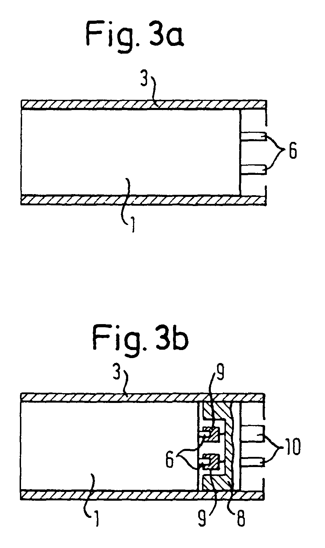

Fig. 3a zeigt eine Schnittdarstellung eines erfindungsgemäßen Sensors, wobei der Schnitt parallel zur Zeichenebene durch die Mittelachse des zylindrischen Formkörpers 1 verläuft. Der Formkörper 1 ist in der bereits beschriebenen Weise vom Hülsenelement 3 umgeben.

Bei der in Fig. 3a gezeigten Ausführungsform sind im Formkörper umspritzte Anschlußstecker 6 vorgesehen, welche aus dem Formkörper 1 herausragen und eine elektrische Kontaktierung des erfindungsgemäßen Sensors ermöglichen. Die Anschlußstecker 6 werden dabei gemeinsam mit der im Sensor vorhandenen Elektronik mit Kunststoffmasse umspritzt, um auf diese Weise den in Fig. 3a dargestellten Formkörper 1 zu erhalten.

Alternativ zu der in Fig. 3a dargestellten Ausführungsform ist es auch möglich, gemäß Fig. 3b im Formkörper 1 lediglich umspritzte Anschlußkontakte 7 vorzusehen, welche nachträglich mit einem an die jeweils gegebenen Anforderungen anpassbaren Anschlußstecker 8 koppelbar sind.

Der Anschlußstecker 8 weist auf seiner den Anschlußkontakten 7 zugewandten Seite Buchsen 9 auf, welche für die Herstellung eines elektrischen Kontaktes zu den Anschlußkontakten 7 sorgen.

Auf seiner den Buchsen 9 abgewandten Seite ist der Anschlußstecker 8 wahlweise mit Steck- oder Buchsenelementen 10 versehen, über welche der dargestellte Sensor an Peripherie anschließbar ist.

Die Außenkontur des Anschlußsteckers 8 entspricht der Außenkontur des Formkörpers 1, so daß beispielsweise der Formkörper 1 von links und der Anschlußstecker 8 von rechts in das Hülsenelement 3 eingeschoben und auf diese Weise elektrisch miteinander verbunden werden können. Ebenso ist es natürlich auch möglich, Formkörper 1 und Anschlußstecker 8 zusammenzufügen, bevor die Einheit aus Formkörper 1 und Anschlußstecker 8 in das Hülsenelement 3 eingeführt wird.

Die zum Anschluß an die Peripherie dienenden Kontakte 10 können beliebig an Kundenwünsche angepaßt werden, während hingegen die Buchsen 9 immer die gleiche Form aufweisen, um so einen einheitlichen Formkörper 1 trotz unterschiedlicher Kontakte 10 verwenden zu können.

Bevorzugt wird der Anschlußstecker 8 im Hülsenelement 3 durch eine Verbindung mit demselben fixiert.

## Patentansprüche

1. Sensor, insbesondere optoelektronischer, induktiver oder magnetischer Sensor mit in einem Gehäuse angeordneten elektronischen Bauteilen und von außen zugänglichen Anschlußelementen,
**dadurch gekennzeichnet,**
daß die elektronischen Bauteile bei weiterhin zugänglichen Anschlußelementen (6, 10) zumindest großteils mit Kunststoffmasse umspritzt sind,
daß die die elektronischen Bauteile umgebende Kunststoffmasse einen festen Formkörper (1) bildet, welcher zumindest teilweise in ein Hülsenelement (3-5) einführbar ist, und
daß Mittel (2) zur Fixierung der relativen Position zwischen Formkörper (1) und Hülsenelement (3-5) vorgesehen sind.

2. Sensor nach Anspruch 1, dadurch gekennzeichnet, daß der Formkörper (1) mit Vertiefungen (2) versehen ist, in die benachbart zu diesen Vertiefungen (2) gelegene Bereiche des Hülsenelements (3) eingedrückt sind, um so Formkörper (1) und Hülsenelement (3) gegeneinander zu fixieren, wobie insbesondere die Vertiefungen (2) die Form zumindest einer Nut, insbesondere einer Ringnut aufweisen.

3. Sensor nach Anspruch 2, dadurch gekennzeichnet, daß das Hülsenelement (3) in seinen benachbart zu einer oder mehreren Ringnuten gelegenen Bereichen gebördelt ist.

4. Sensor nach einem der vorhergehenden Ansprüche, dadurch gekennzeichnet, daß das Hülsenelement (3-5) an einer oder an mehreren Stellen am Formkörper (1) fixiert und insbesondere vollflächig mit diesem verbunden ist, und/oder daß das Hülsenelement (3-5) auf den Formkörper (1) aufgeschrumpft oder aufgeschraubt ist.

5. Sensor nach einem der vorhergehenden Ansprüche, dadurch gekennzeichnet, daß das Hülsenelement (3-5) auf seiner Innenseite mit einem Gewinde, insbesondere mit einem selbstschneidenden Gewinde zur Erzeugung eines Gewindes auf der Außenseite des Formkörpers (1) versehen ist, und/oder daß Hülsenelement (3-5) und Formkörper (1) miteinander verklebt und/oder verpreßt sind, und/oder daß der Formkörper (1) mit dem Hülsenelement (3-5) galvanisch überzogen ist.

6. Sensor nach einem der vorhergehenden Ansprüche, dadurch gekennzeichnet, daß das Hülsenelement (3-5) im wesentlichen eine hohlzylindrische Form aufweist, und/oder daß die Außenkontur des Hülsenelements (3-5) eine quadratische oder rechteckige Form aufweist.

7. Sensor nach einem der vorhergehenden Ansprüche, dadurch gekennzeichnet, daß das Hülsenelement (3-5) die ihm zugewandte Außenseite des Formkörpers (1) teilweise oder vollständig bedeckt, und/oder daß das Hülsenelement (3-5) aus Metall oder Kunststoff besteht, und/oder daß die Außenseite des Hülsenelements (3-5) im wesentlichen glatt ausgebildet oder mit einem Gewinde versehen ist.

8. Sensor nach einem der vorhergehenden Ansprüche, dadurch gekennzeichnet, daß der Formkörper (1) in Hülsenelementen (3-5) unterschiedlicher Abmessungen fixierbar ist, und/oder daß der Formkörper (1) in unterschiedlichen hohlzylindrischen Hülsenelementen (3-5) mit jeweils gleichem, dem Außenumfang des Formkörpers (1) entsprechenden Innenumfang und mit unterschiedlichem Außenumfang bzw. unterschiedlicher Außenkontur fixierbar ist.

9. Sensor nach einem der vorhergehenden Ansprüche, dadurch gekennzeichnet, daß im Formkörper (1) ein umspritzter Anschlußstecker vorhanden ist, oder daß im Formkörper (1) umspritzte Anschlußkontakte (7) zur nachträglichen Kopplung mit einem an die jeweiligen Anforderungen anpassbaren Anschlußstecker (8) vorhanden sind.

10. Sensor nach Anspruch 9, dadurch gekennzeichnet, daß der nachträglich angekoppelte Anschlußstecker (8) zumindest bereichsweise vom Hülsenelement (3) umgeben und bevorzugt mit diesem verbunden und auf diese Weise fixiert ist.

11. Verfahren zur Herstellung eines Sensors nach einem der vorhergehenden Ansprüche,
**dadurch gekennzeichnet,**
daß zuerst das Formteil (1) und das Hülsenelement (3-5) als zwei voneinander unabhängige Bauteile hergestellt werden und anschließend das Formteil (1) in das Hülsenelement (3-5) eingeführt und in diesem fixiert wird.
